# DEMANDE DE BREVET EUROPEEN

(11) **EP 2 975 650 A1**
(43) Date de publication de la demande: **20.01.2016**
(21) Numéro de dépôt: 15182078.4
(22) Date de dépôt: 22.08.2014
(51) Int. Cl.: H01L 31/0232, H01L 27/146, H01L 31/107

(54) **PHOTODIODE À HAUT RENDEMENT QUANTIQUE**

(30) Priorité: 23.08.2013 FR 1358138
(62) Demande divisionnaire de: 14181921.9
(71) Demandeur: COMMISSARIAT A L'ENERGIE ATOMIQUE ET AUX ENERGIES ALTERNATIVES, 75015 Paris (FR); STMicroelectronics (Crolles 2) SAS, 38920 Crolles (FR); STmicroelectronics SA, 92120 Montrouge (FR)
(72) Inventeur: MARTY, Michel, 38760 SAINT PAUL DE VARCES (FR); JOUAN, Sébastien, 38920 CROLLES (FR); FREY, Laurent, 38600 FONTAINE (FR); BOUTAMI, Salim, 38100 GRENOBLE (FR)
(74) Mandataire: Thibon, Laurent

(57) **Abrégé**

L'invention concerne une photodiode comprenant un réseau de plots disposés sur la surface photo-réceptrice de la photodiode, chaque plot étant en un premier matériau (20) dont les parois latérales sont entourées d'au moins un espaceur (22) en un deuxième matériau d'indice optique distinct de celui du premier matériau, les dimensions latérales du plot étant inférieures à la longueur d'onde de fonctionnement de la photodiode, les premier et deuxième matériaux étant transparents à la longueur d'onde de fonctionnement et le pas du réseau étant de l'ordre de la longueur d'onde de fonctionnement de la photodiode.

## Description

### Domaine

La présente demande concerne les diodes photoréceptrices ou photodiodes à semiconducteurs, utilisées par exemple comme pixels d'un capteur d'image, ou comme photodiodes à photon unique.

### Exposé de l'art antérieur

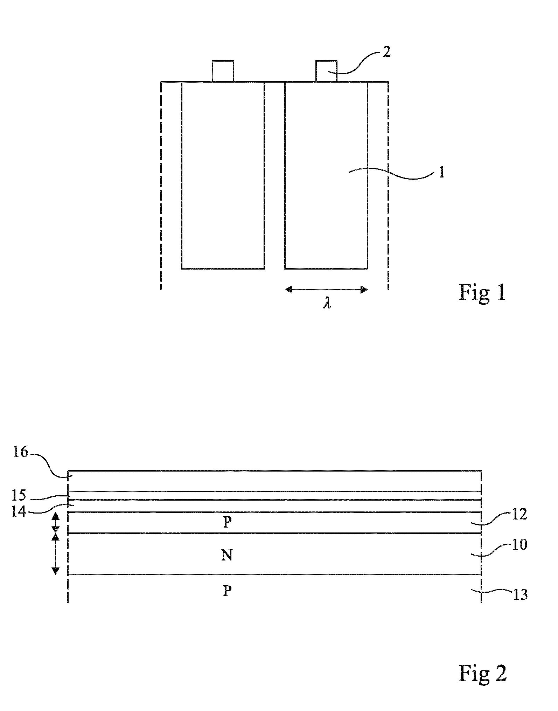

La figure 1 représente de façon simplifiée et partielle deux photodiodes côte à côte d'un réseau de photodiodes constituant par exemple un capteur d'image. Chaque photodiode comprend une zone semiconductrice 1 de conversion de photons en paires électrons-trous. Dans une photodiode complète, il existe des jonctions (non représentées) entre des régions semiconductrices de type opposé pour stocker les photons, et divers transistors de lecture pour transférer les électrons.

La demande de brevet PCT WO2012/032495 expose que, quand les dimensions latérales de la surface éclairée (la surface supérieure en figure 1) d'une photodiode sont très faibles, de l'ordre de la longueur d'onde λ de la lumière que la photodiode est destinée à capter, ou longueur d'onde de fonctionnement, il se pose un problème pour introduire la lumière dans la photodiode. Ainsi, le rendement quantique de telles photodiodes de très petites dimensions est faible. Cette demande de brevet propose, pour augmenter le rendement quantique de la photodiode, de disposer sur la surface supérieure de celle-ci un plot 2 dont les dimensions latérales sont nettement inférieures aux dimensions latérales de la photodiode.

La figure 2 représente de façon simplifiée et partielle la partie détectrice d'une diode à avalanche à photon unique, couramment désignée par le sigle SPAD (de l'anglais : Single Photon Avalanche Diode). Dans une telle diode, on trouve une structure constituée d'une couche semiconductrice de type N 10 pincée entre deux couches semiconductrices 12 et 13 de type opposé. Le problème est que la couche 10 est, dans les technologies modernes, très mince, d'une épaisseur de l'ordre de seulement 1 à 1,5 µm. C'est dans cette couche 10 que doit se faire la conversion utile des photons en paires électrons-trous, alors que l'on sait que, dans le cas du silicium et pour un rayonnement infrarouge, il faut que la couche dans laquelle doivent se créer les paires électrons trous ait une épaisseur supérieure à 10 µm, pour espérer obtenir un taux de conversion des photons supérieur à 90 %. Ainsi, le rendement d'une diode SPAD fabriquée par les technologies actuelles est seulement de l'ordre de 5 à 7 %. Pour améliorer ce rendement et ne pas perdre de lumière réfléchie, on dispose au-dessus de la couche supérieure semiconductrice 12 une structure antireflet, comprenant alternativement au moins une couche de matériau à bas indice 14, par exemple de l'oxyde de silicium, et une couche de matériau à plus haut indice 15, par exemple du nitrure de silicium. La couche supérieure 16, de protection, est couramment une couche d'oxyde de silicium.

Ainsi, il se pose un problème pour absorber le maximum de photons possible dans des structures à pixels de petites dimensions telles que celles représentées en figure 1, et dans des structures dans lesquelles la couche de conversion de photons en paires électrons-trous est particulièrement mince, telles que la structure SPAD de la figure 2. Plus généralement, ce problème se pose plus ou moins dans toutes les photodiodes à semiconducteur.

On notera que, dans des photodiodes de très petites dimensions ou des photodiodes de type SPAD, une augmentation, même faible, du rendement quantique ou taux d'absorption de la partie utile de la photodiode est en pratique extrêmement importante pour la détection de lumière de faible intensité. Ainsi, un gain de rendement de 1 à 5 % sera considéré comme un gain très important par l'utilisateur.

### Résumé

Ainsi, un mode de réalisation prévoit une photodiode comprenant au moins un plot central disposé sur la surface photoréceptrice de la photodiode, le ou les plots étant en un premier matériau dont les parois latérales sont entourées d'au moins un espaceur en un deuxième matériau d'indice optique distinct de celui du premier matériau, les dimensions latérales du plot étant inférieures à la longueur d'onde de fonctionnement de la photodiode, les premier et deuxième matériaux étant transparents à la longueur d'onde de fonctionnement.

Selon un mode de réalisation, le premier matériau a un indice n1 différent de l'indice n2 du deuxième matériau, chacun des indices n1 et n2 étant inférieur ou égal à l'indice n_{SC} du matériau semiconducteur constituant la photodiode.

Selon un mode de réalisation, la photodiode est revêtue d'une couche de protection en un matériau d'indice n3 inférieur à n1 et n2.

Selon un mode de réalisation, la surface photoréceptrice a des dimensions latérales de l'ordre de la longueur d'onde de fonctionnement, cette photodiode étant revêtue d'un unique plot.

Selon un mode de réalisation, la surface photoréceptrice a des dimensions latérales de l'ordre de plusieurs longueurs d'onde de fonctionnement, cette photodiode étant revêtue d'un réseau de plots à un pas de l'ordre de la longueur d'onde de fonctionnement de la photodiode.

Selon un mode de réalisation, la photodiode est de type SPAD.

Selon un mode de réalisation, la photodiode est constituée à partir de silicium, et les plots sont des plots de silicium polycristallin entourés d'espaceurs en nitrure de silicium.

Un mode de réalisation prévoit un procédé de fabrication d'une photodiode comprenant une étape préalable de réalisation d'une simulation pour déterminer, en fonction des matériaux choisis et de la longueur d'onde de fonctionnement, les dimensions et le pas des plots.

Selon un mode de réalisation, les étapes de fabrication des plots et des espaceurs sont réalisées en même temps que des étapes de fabrication de grilles de transistors MOS.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente très schématiquement, en coupe, une partie de deux photodiodes de petites dimensions ;
la figure 2 représente très schématiquement, en coupe, une partie d'une photodiode de type SPAD ;
la figure 3 représente, en coupe, un mode de réalisation de pixels de photodiodes de petites dimensions ;
la figure 4A représente, en coupe, un mode de réalisation d'une photodiode de type SPAD ;
la figure 4B est une vue de dessus agrandie d'une partie de la figure 4A ;
les figures 5A, 5B et 5C sont des vues en coupe schématiques d'une partie de la région supérieure de photodiodes de différents types ;
la figure 6 est une courbe représentant l'absorption d'une photodiode du type de celle des figures 4A et 4B ou 5C en fonction de la largeur d'espaceurs ;
la figure 7 représente le gain d'absorption dans une photodiode du type à plots et espaceurs par rapport au cas d'une photodiode à plots sans espaceurs, pour diverses valeurs de paramètres de largeur de plot et de distance entre plots ; et
les figures 8A et 8B représentent des exemples de modes de réalisation de plots disposés sur des photodiodes.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

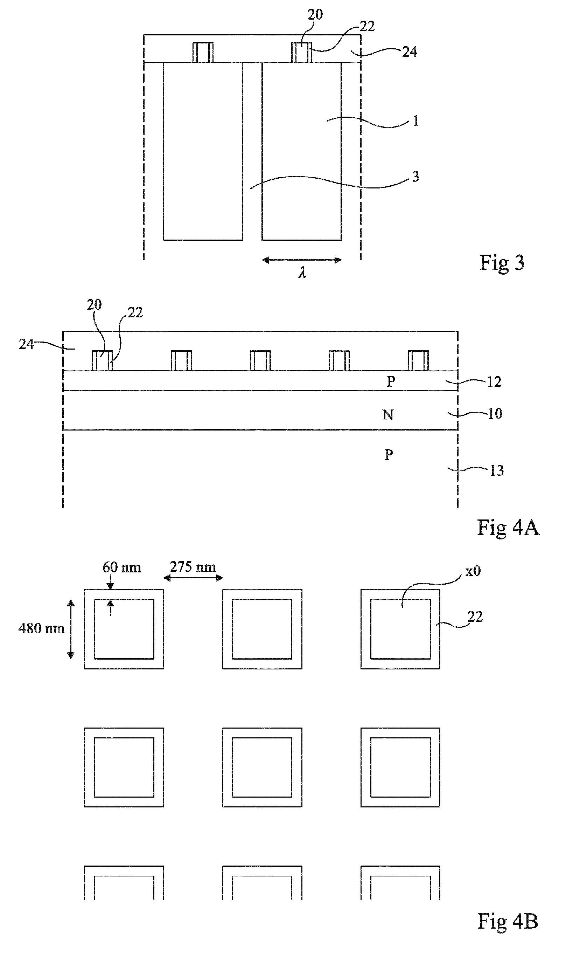

La figure 3 représente un mode de réalisation de deux pixels adjacents, illustrés de façon très schématique sous forme de deux régions 1 d'un matériau semiconducteur, par exemple du silicium, dans lequel s'effectue une transformation de photons en paires électrons-trous. Deux régions semiconductrices voisines 1 sont séparées, par exemple, par une région isolante 3. Chaque région semiconductrice est représentée de façon très schématique. En pratique, chaque région semiconductrice comprend, comme on l'a indiqué précédemment, des jonctions pour permettre un stockage de l'un des porteurs de chaque paire électron-trou, couramment des électrons. On considère ici, comme en figure 1, le cas dans lequel les dimensions latérales de la photodiode sont de l'ordre de grandeur de la longueur d'onde de la lumière que la photodiode est destinée à capter ou longueur d'onde de fonctionnement de la photodiode.

Sur la surface supérieure de la photodiode sont formés des plots comprenant un plot central 20 revêtu latéralement d'une couche 22. La couche 22 correspond à ce qui est couramment appelé un espaceur dans le domaine de la fabrication des transistors MOS sur semiconducteur. L'ensemble de la structure supérieure est revêtu d'une couche isolante 24 qui est couramment surmontée d'une couche de filtrage et d'une lentille propre à chaque pixel (non représenté). Le plot central est en un premier matériau d'indice n1 différent de l'indice n2 du matériau de l'espaceur. La couche 24 est en un matériau d'indice n3 inférieur à n1 et n2. Les matériaux du plot central 20 et des couches 22 et 24 sont transparents à la longueur d'onde de fonctionnement de la photodiode. Chacun des indices n1 et n2 est inférieur à l'indice n_{SC} du semiconducteur 1, l'un des deux pouvant toutefois être égal à n_{SC}. A titre d'exemple, dans le cas où le semiconducteur 1 est du silicium et a une longueur d'onde de fonctionnement de 850 nm, le matériau 20 peut être du silicium polycristallin d'indice n1=3,6 et le matériau n2 peut être du nitrure de silicium stoechiométrique ou non, SiN, d'indice n2=2. Le plot 20 a des dimensions latérales nettement inférieures à la longueur d'onde, par exemple comprises entre le dixième et le tiers de la longueur d'onde et la couche latérale ou espaceur 22 a une largeur moyenne de l'ordre de 20 à 60 nm. Ce plot peut avoir une forme quelconque, par exemple ronde, carrée, ovale, rectangulaire.

On constate, comme cela sera exposé ci-après, qu'une telle structure, convenablement dimensionnée, augmente de quelques pourcents la quantité de conversion de photons en paires électrons-trous dans la région semiconductrice 10. Ceci est attribué au fait que la présence du plot central 20, en un matériau transparent à la lumière considérée, produit, d'une part des effets de diffraction et que ces effets de diffraction sont accentués par la présence de l'espaceur 22 et/ou, d'autre part, un effet antireflet qui s'améliore également avec la présence de l'espaceur 22. Certains des photons se déplacent alors obliquement, et non plus verticalement, dans le semiconducteur, ce qui augmente leur probabilité d'absorption.

La figure 4A est une vue en coupe d'une diode de type SPAD de même type que celle de la figure 2, comprenant comme elle une couche 10 de transformation de photons en paires électrons-trous d'un premier type de conductivité, par exemple de type N, encadrée par deux couches 12 et 13 du type de conductivité opposé. La structure est recouverte d'un réseau de plots dont chacun comprend une partie centrale 20 entourée d'un espaceur 22. Les plots sont de même type que celui décrit en relation avec la figure 3.

La figure 4B est une vue de dessus d'un exemple de réalisation. Dans le cas où le semiconducteur est du silicium et où le rayonnement que la photodiode est destinée à accepter a une longueur d'onde λ, le pas des plots peut être égal à 2λ/3 à 20 % près, les dimensions latérales des plots peuvent être comprises entre le dixième et le tiers de la longueur d'onde et la distance entre les plots peut être de l'ordre du quart aux deux tiers de la longueur d'onde. L'épaisseur des plots est préférentiellement inférieure à la moitié de la longueur d'onde. Dans l'exemple représenté où les plots sont en silicium polycristallin, les espaceurs sont en nitrure de silicium, et la longueur d'onde de fonctionnement est de 850 nm, on pourra choisir, à titre d'exemple :
- des dimensions latérales de plots de 400 nm,
- des distances entre plots de 150 nm,
- des largeurs d'espaceurs de 40 nm, et
- des épaisseurs de plots et d'espaceurs de 180 nm.

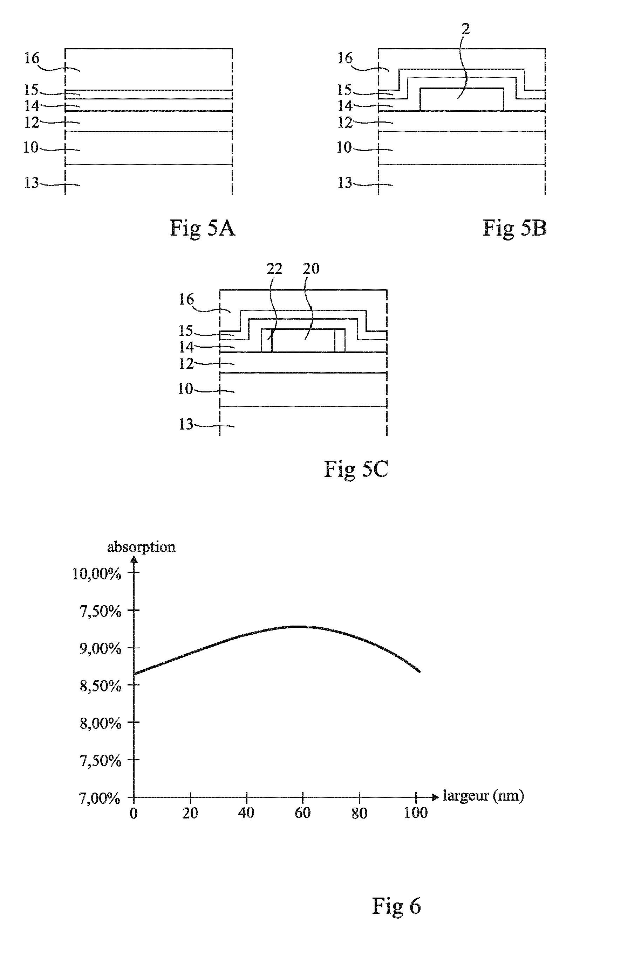

Les figures 5A, 5B, 5C représentent, dans un but comparatif, respectivement, un motif d'une structure sans plots, d'une structure avec plots mono-matériau et d'une structure avec plots et espaceurs. En figure 5A, la structure n'est recouverte d'aucun plot mais seulement d'une couche antireflet, désignée par les mêmes références qu'en figure 2. En figure 5B, la structure est revêtue de plots mono-matériau 2 tels que celui de la figure 1 et est munie d'un revêtement antireflet. En figure 5C, la structure est munie de plots 20 entourés d'espaceurs 22 et est également munie d'un revêtement antireflet.

Des mesures comparatives ont été faites pour chacune des trois structures des figures 5A, 5B et 5C dans le cadre de l'exemple numérique ci-dessus. Le tableau ci-dessous indique, dans chacun des trois cas, pour une photodiode de type SPAD, à motifs périodiques, l'absorption de photons en % dans la couche 10 quand cette couche 10 a une épaisseur de 1,5 µm, l'absorption de photons en % dans la couche 12 quand cette couche 12 a une épaisseur de 1 µm, et le pourcentage de lumière réfléchie.

| | SANS PLOTS | AVEC PLOTS | AVEC PLOTS ET ESPACEURS |
|---|---|---|---|
| Absorption (Si=1,5 µm) | 8 | 8,6 | 9,2 |
| Absorption (Si=1 µm) | 5,7 | 6,3 | 6,7 |
| Réflexion | 6,8 | 4,1 | 1,5 |

Des résultats similaires sont obtenus pour une photodiode dont les dimensions latérales sont de l'ordre de grandeur de la longueur d'onde de fonctionnement, munie d'un plot unique.

La figure 6 est une courbe illustrant l'absorption de photons en % dans la couche 10 pour une photodiode munie de plots pour diverses valeurs de largeur d'espaceur. On voit qu'en l'absence d'espaceurs, cette absorption est de l'ordre de 8,6 % et qu'elle croît à une valeur supérieure à 9 % pour des largeurs de plots comprises entre environ 30 et environ 90 nm, un maximum étant atteint, à environ 9,3 % pour une largeur d'espaceur de l'ordre de 60 nm.

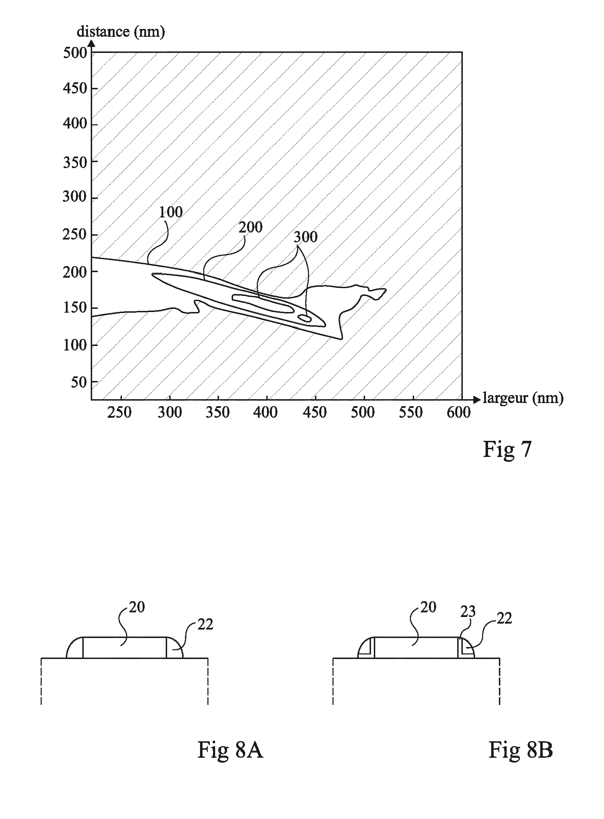

La figure 7 montre que, en fonction de la longueur d'onde et des divers paramètres d'une structure dont la largeur des espaceurs, le choix de la dimension des plots et de l'intervalle entre plots est crucial pour l'obtention de l'effet recherché d'amélioration de l'absorption des photons. L'abaque de la figure 7 est tracé pour des espaceurs d'une largeur de 40 nm, pour une longueur d'onde de 850 nm, pour une photodiode à base de silicium, et pour des plots en silicium polycristallin bordés d'espaceurs en nitrure de silicium. Les abscisses indiquent des dimensions latérales de plots et les ordonnées des distances entre plots. La courbe 100 délimite une zone à l'intérieur de laquelle l'absorption avec plots et espaceurs est supérieure à l'absorption avec plots sans espaceurs. La courbe 200 délimite une zone à l'intérieur de laquelle l'absorption avec espaceurs est supérieure de 4 % à l'absorption sans espaceurs. La courbe 300 délimite une zone à l'intérieur de laquelle l'absorption avec espaceurs est supérieure de 6 % à l'absorption sans espaceurs. Ainsi, dans ce cas particulier, on voit que le gain d'absorption induit par les espaceurs est maximum quand la largeur des plots est comprise entre environ 350 et environ 450 nm et l'espace entre plots est compris entre environ 150 et environ 180 nm.

De façon générale, l'homme de métier pourra obtenir l'abaque de la figure 7 et réaliser une optimisation des dimensions par des procédés classiques de simulation, en utilisant des programmes de simulation tels que le logiciel DiffractMOD (www.rsoftdesign.com) ou le logiciel Grating Toolbox (www.lighttrans.com). Ainsi, moyennant ce calcul de simulation préalable, l'homme de l'art pourra, sans tâtonnements, réaliser des plots munis d'espaceurs de dimensions convenables pour augmenter le rendement quantique ou absorption de photons d'une photodiode.

Les figures 8A et 8B représentent des exemples de réalisation pratique des plots munis d'espaceurs tels que décrits précédemment. En effet, on notera qu'une structure de type photodiode est généralement associée, dans et sur un même substrat semiconducteur, à des transistors MOS comprenant des grilles dont une partie au moins est en silicium polycristallin, ces grilles étant munies d'espaceurs, couramment en nitrure de silicium. Ainsi, on pourra tout simplement utiliser comme le représente la figure 8A un plot 20 en silicium polycristallin encadré d'espaceurs en nitrure de silicium 22. Selon une variante, illustrée en figure 8B, entre un plot 20 et l'espaceur 22 est prévue une mince couche de matériau intermédiaire 23, comme cela est couramment utilisé dans la réalisation d'espaceurs pour des transistors MOS. Il en résulte que les plots munis d'espaceurs décrits ici peuvent être fabriqués sans modifier une filière technologique classique de fabrication de photodiodes et de transistors CMOS.

On notera également que les plots selon l'invention peuvent reposer sur une très mince couche d'isolant tel que l'isolant de grille de transistors MOS, ayant couramment une épaisseur de l'ordre de seulement quelques nm.

Bien entendu, la présente invention est susceptible de nombreuses variantes et modifications en ce qui concerne notamment les matériaux utilisés qui peuvent être tous matériaux choisis, à condition qu'ils soient transparents à la longueur d'onde de fonctionnement et qu'ils respectent les relations exposées précédemment entre les indices n1, n2, n3 et l'indice n_{SC} du semiconducteur de la photodiode. Si la technologie amène à utiliser d'autres matériaux que du silicium polycristallin, du nitrure de silicium et de l'oxyde de silicium, des programmes de simulation tels que ceux indiqués précédemment permettront de déterminer les dimensions optimales des plots et les pas des réseaux à utiliser, sans tâtonnements.

## Revendications

1. Photodiode dont la surface photoréceptrice a des dimensions latérales de l'ordre de plusieurs longueurs d'onde de fonctionnement, cette photodiode étant revêtue d'un réseau de plots à un pas de l'ordre de la longueur d'onde de fonctionnement de la photodiode en contact avec la surface semiconductrice photoréceptrice (12) de la photodiode, lesdits plots étant en un premier matériau dont les parois latérales sont entourées d'au moins un espaceur (22) en un deuxième matériau d'indice optique distinct de celui du premier matériau, les dimensions latérales des plots étant inférieures à la longueur d'onde de fonctionnement de la photodiode, les premier et deuxième matériaux étant transparents à la longueur d'onde de fonctionnement.

2. Photodiode selon la revendication 1, dans laquelle le premier matériau a un indice n1 différent de l'indice n2 du deuxième matériau, chacun des indices n1 et n2 étant inférieur ou égal à l'indice n_{SC} du matériau semiconducteur constituant la photodiode.

3. Photodiode selon la revendication 2, revêtue d'une couche de protection (24) en un matériau d'indice n3 inférieur à n1 et n2.

4. Photodiode selon la revendication 1 de type SPAD.

5. Photodiode selon l'une quelconque des revendications 1 à 4, constituée à partir de silicium, dans laquelle les plots sont des plots de silicium polycristallin entourés d'espaceurs en nitrure de silicium.

6. Procédé de fabrication d'une photodiode selon l'une quelconque des revendications 1 à 5, comprenant une étape préalable de réalisation d'une simulation pour déterminer, en fonction des matériaux choisis et de la longueur d'onde de fonctionnement, les dimensions et le pas des plots.

7. Procédé selon la revendication 6, dans lequel les étapes de fabrication des plots et des espaceurs sont réalisées en même temps que des étapes de fabrication de grilles de transistors MOS.
